# EUROPÄISCHE PATENTANMELDUNG

(11) **EP 2 369 356 A2**
(43) Veröffentlichungstag der Anmeldung: **28.09.2011**
(21) Anmeldenummer: 11000298.7
(22) Anmeldetag: 15.01.2011
(51) Int. Cl.: G01R 31/28

(54) **Verfahren und Vorrichtung zum Auffinden leistungsschwacher PV-Module in einer PV-Anlage mittels des Einsatzes von Trennschaltern**

(30) Priorität: 24.02.2010 DE 102010009079
(71) Anmelder: Adensis GmbH, 01129 Dresden (DE)
(72) Erfinder: Beck, Bernhard, 97332 Volkach OT Dimbach (DE)

(57) **Zusammenfassung**

Es wird ein Messverfahren zur Ermittlung eines Leistungsabfalls einer PV-Einheit (S,F) vorgeschlagen. Die PV-Einheit (F,S) liegt innerhalb einer mehrere, elektrisch parallel geschaltete PV-Einheiten (S,F) umfassenden Photovoltaikanlage. Jede PV-Einheit ist mittels einer Schaltvorrichtung (T₁ bis T₈) aus der Parallelschaltung herausnehmbar ist. Ferner ist ein Gesamtstrommessgerät (3) zur Messung des Gesamtstroms (I) durch alle PV-Einheiten der Parallelschaltung vorgesehen. Durch zu- und abschalten der Trennmittel (T₁ bis T₈) wird die defekte PV-Einheit in einer Auswerteeinheit (7) ermittelt.

## Beschreibung

Die Erfindung bezieht sich auf ein Verfahren zum Auffinden eines Strangs mit einem leistungsschwachen PV-Modul innerhalb einer größeren PV-Anlage mit mehreren, elektrisch parallel geschaltete PV-Einheiten (S,F) und mit einem Gesamtstrommessgerät zur Messung des Gesamtstroms durch alle PV-Einheiten der Parallelschaltung und auf eine zugeordnete Vorrichtung zur Durchführung des Verfahrens.

Große PV-Anlagen können Tausende von PV-Modulen umfassen, die einzeln ausgemessen werden müssen, um ein schadhaftes Modul zu erkennen und zu lokalisieren. Dieser Aufwand ist notwendig, da das Vorhandensein eines einzigen oder auch mehrerer leistungsschwacher, wenn nicht sogar defekter Module bei der Gesamtleistung nicht weiter auffällt. Ein defektes Modul, bei dem eine Photovoltaikzelle nichtleitend ist oder bei dem die Lötverbindung zwischen zwei Zellen unterbrochen ist, führt zu einem Ausfall des gesamten Stranges von z.B. zehn in Serie geschalteten PV-Modulen, da eine einzige Unterbrechung auch die Serienverbindung unterbricht. Bei einer Gesamtleistung von 2 MW der Photovoltaikanlage entspricht der Beitrag eines Strangs von z.B. 2 KW einem Tausendstel der Leistung. Selbst mehrere über die Zeit defekte oder leistungsschwache Stränge fallen nicht sofort auf, da die Abweichung in der generierten Leistung auch Wetter bedingt sein kann und die Messgenauigkeit der verwendeten Stromwandler bei Messung von Strömen im unteren Bereich des dem Messgerät inhärenten Messbereichs nicht hinreichend genau ist, um selbst bei konstantem Wetter so geringe Abweichungen zu erkennen. Die Abweichungen sind bei den üblicherweise verwendeten, auf Magnetfeldbasis beruhenden Strommesswandlem Bauart bedingt. Permanent installierte Systeme zur Leistungsmessung sind mit einem nicht vertretbaren Kostenaufwand verbunden.

Neben obigem Problem der nicht entdeckten Minderleistungsfähigkeit der PV-Anlage ist es insbesondere im Garantiezeitraum wichtig, dass gerechtfertigte Reklamationsmöglichkeiten erkannt werden, um den Hersteller des defekten PV-Moduls in die Pflicht zu nehmen.

Mit dem heutigen Stand der Technik sind verschiedene Möglichkeiten der Überprüfung der Leistungsfähigkeit von PV-Modulen bekannt. Bei allen Verfahren, welche ein aussagekräftiges Ergebnis liefern, muss die PV-Anlage vom Wechselrichter entkoppelt und an ein Messgerät angeschlossen werden.

Als Messgerät kommen hierbei Multimeter zum Einsatz, in dem diese den Kurzschlussstrom und die Leerlaufspannung eines PV-Moduls, eines Strangs mit mehreren, seriell hintereinander angeordneten PV-Modulen oder einer PV-Einheit bestimmen. Ziel dieser Messung ist es, die grundsätzliche Funktion des PV-Moduls, Stranges bzw. der PV-Einheit zu erkennen.

Soll die Leistungsfähigkeit eines PV-Moduls, Stranges oder einer PV-Einheit ermittelt werden, so geschieht dies vorzugsweise durch das Anschließen eines U-l-Kennlinienmessgerätes, welches die entsprechende U-l-Kennlinie messen kann. Die so gemessene Kennlinie wird ergänzt um den Messwert eines Einstrahlungssensors bzw. einer Referenzsolarzelle sowie des Messwertes eines Temperaturfühlers, welcher die Temperatur des PV-Moduls misst. Der STC - Leistungswert (Standardisierter Leistungswert für Photovoltaikmodule) errechnet sich aus den oben genannten Werten von Einstrahlung, Temperatur, Spannung und Strom . Dieser hat jedoch aufgrund der vielen Toleranzen bei den Sensoren, welche zur Berechnung herangezogen werden, eine hohe Ungenauigkeit.

Weiterhin ist aus dem Stand der Technik das Messen mit einer Stromzange bekannt, mit der man im laufenden Betrieb die Stromstärke eines PV-Moduls, Stranges oder einer PV-Einheit ermitteln kann. Da jedoch Spannung, Einstrahlung und Temperatur unbekannt sind, genügt diese Art der Messung lediglich der reinen Überprüfung der Funktionalität sowie der Überprüfung von Sicherungen. Alle zum Stand der Technik gehörenden Verfahren und Vorrichtungen stellen hinsichtlich ihrer Genauigkeit, des für die Messung benötigten Zeitaufwands und ihrer Anwendbarkeit während des Betriebes keine ausreichend zufriedenstellende Lösung dar.

So liegt vorliegender Erfindung die Aufgabe zugrunde, einen defekten oder leistungsschwachen Strang, in welchem ein defektes bzw. leistungsschwaches PV-Modul sein muss, mit wenig technischem und zeitlichem Aufwand und möglichst geringer Störung des Betriebs zu erkennen.

Diese Aufgabe wird bezüglich des Verfahrens mit folgenden Schritten gelöst:
i) der aufsummierte Gleichstrom aller parallel geschalteter PV-Einheiten wird mit dem Gesamtstrommessgerät erfasst und dessen Wert abgespeichert,
ii) eine der PV-Einheiten wird mittels der ihr zugeordneten Schaltvorrichtung aus der Parallelschaltung herausgenommen,
iii) der aufsummierte Gleichstrom durch alle PV-Einheiten, bis auf die herausgenommene PV-Einheit, wird mit dem Gesamtstrommessgerät ermittelt und dessen Wert abgespeichert,
iv) der Schalter der herausgenommenen PV-Einheit wird geschlossen, so dass die PV-Einheit wieder in die Parallelschaltung integriert ist,
v) die Schritte ii) bis iv) werden für alle PV-Einheiten der Parallelschaltung durchgeführt, und
vii) die abgespeicherten Stromwerte werden einer Auswerteeinheit zur Verfügung gestellt.

Im ersten Verfahrensschritt wird der Gesamtstrom der an einem Wechselrichter angeschlossenen PV-Anlage gemessen. Dieser beträgt zum Beispiel 50 Ampere bei einer PV-Anlage mit fünf Feldern zu je 10 Strängen von jeweils 10 PV-Modulen. Im Durchschnitt produziert also jedes Feld 10 Ampere. Wird das erste Feld aus der Parallelschaltung herausgenommen, ergibt sich z.B. ein Stromwert für die verbleibenden vier Felder von 40 Ampere. Das heißt, dass das isolierte Feld genau den Durchschnittswert (10 A) zum Gesamtstrom von 50 Ampere beigesteuert hat. Anschließend wird der dem ersten Feld zugeordnete Schalter wieder geschlossen und der Schalter eines anderen der fünf Felder wird geöffnet, so dass dann dieses Feld keinen Beitrag zum Gesamtstrom liefert. Eine erneute Messung des Gesamtstrom durch die verbleibenden vier Felder ergibt beispielsweise einen Wert von 40,7 Ampere. Folglich hat das zweite herausgenommene Feld lediglich einen Strombeitrag von 9,3 A geliefert. Der diesem Feld zugeordnete Schalter wird wieder geschlossen, und der Schalter eines dritten Feldes wird geöffnet. Am Zahlenbeispiel ergeben sich für die restlichen drei Felder Stromwerte beim Gesamtstrom von 39,7 A, 39,7 A und 39,9 A, was einem jeweiligen Feldstrom von 10,3A, 10,3A beziehungsweise 10,1 Ampere entspricht. Die Gesamtsumme aller fünf Felder von 50A setzt sich also aus der Summe der Feldeinzelströme von 10A, 9,3A,10,3A, 10,3A und 10,1A zusammen. Aus diesem Ergebnis kann unmittelbar der Rückschluss gezogen werden, dass das an zweiter Stelle gemessene Feld einen Defekt hat und weiter zu untersuchen wäre. Sollte auch in jedem Strang der einzelnen Felder ein Schalter vorgesehen sein, kann auf die gleiche Weise der (oder die) minderleistende(n) Strang (Stränge) ermittelt werden.

Bei dem Messverfahren ist es vorteilhaft, wenn im fünften Schritt jedes mal auch der erste Schritt mit einbezogen wird. Es wird zwar bei konstanten Wetterverhältnissen gemessen, aber dann können auch geringe Abweichungen im Gesamtstrom aufgrund von einer Einstrahländerung, einer Temperaturänderung des Halbleiters etc. eliminiert werden. Das gilt insbesondere, wenn die einzelnen unter Wegfall eines Feldes gemessenen Gesamtströme zum zuvor gemessenen Gesamtstrom aller Felder ins Verhältnis gesetzt werden.

Um die einzelnen Messungen aller Felder gut vergleichbar zu machen, ist es angeraten dass die PV-Einheiten während der Verfahrensschritte i) bis v) auf den gleichen Betriebsspannungswert gesetzt werden. Am Zahlenbeispiel wäre der Einzelbeitrag der Felder dann entsprechend 20% (10/50), 18,6% (9,3/50), 20,6% (10,3/50), 20,6% (10,3/50) und 20,2% (10,1/50). Je nach dem von den Herstellern der PV-Module garantierten Toleranzbereiche und dem vom Errichter der PV-Anlage montageseitig vermuteten Toleranzabweichung, wäre bei dem zuvor geschilderten Beispiel eventuell auch noch das erste Feld näher zu untersuchen, da es mit 10A zwar den Durchschnitt erreicht, im Vergleich zu drei anderen Feldern aber immerhin in seiner Leistungsfähigkeit abfällt.

Um die einzelnen Messungen aller Felder gut vergleichbar zu machen, ohne das für geänderte Spannungen Korrekturfaktoren erforderlich sind, ist es angeraten dass die PV-Einheiten während der Verfahrensschritte i) bis v) auf den gleichen Betriebsspannungswert gesetzt werden.

Eine besonderer Vorteil ist es, das Messverfahren so weiterzubilden, dass die Auswerteeinheit die zu einem Zeitpunkt t₀ abgespeicherten Strommesswerte mit den entsprechenden, zu einem späteren Zeitpunkt t₁ ermittelten Strommesswerten vergleicht. Dieses zusätzliche Merkmal ermöglicht nicht nur die Überprüfung der PV-Anlage nach der Errichtung auf Modul- oder Montagefehler, sondern es kann zu einem beliebigen Zeitpunkt auf einfache Weise die Funktionsfähigkeit der PV-Felder oder der PV-Stränge überprüft werden. So kann z.B. kurz vor Ablauf der Garantiezeit auf die PV-Module ein Mess-Scan der beispielhaft genannten Art durchgeführt werden, bei dem sofort auffällt, wenn ein Modul eine Unterbrechung zwischen zwei Zellen hat. Zu einem späteren Zeitpunkt kann festgestellt werden, welche Felder normales Degradationsverhalten haben oder welche Felder, Stränge oder Module schneller gealtert sind, als es zugesagt wurde.

Zur Erzielung einer hohen Zuverlässigkeit der abgespeicherten Stromwerte, Verhältnisse oder anderer Verknüpfungen ist es sinnvoll, die Strommessung kurz (z.B. einige Millisekunden) hintereinander mehrere Male, z.B. fünf bis zehn Mal, vorzunehmen und das arithmetische Mittel über die kurz hintereinander vorgenommenen Strommessungen zu bilden.

Soll als auf Fehler zu untersuchende PV-Einheit ein Strang angesehen werden, so ist jedem Feld ein eigener stationärer Stromsensor zuzuordnen, der dann zum Gesamtstrommessgerät im Sinne vorliegender Ansprüche wird. Ist es ein Feld, welches auf einen Fehler hin untersucht werden soll, so ist das Gesamtstrommessgerät in der Zuführungsleiter zum Wechselrichter vorzusehen.

Bezüglich der Vorrichtung wird die eingangs vorgebrachte Aufgabe durch eine mehrere, elektrisch parallel geschaltete PV-Einheiten (S,F) umfassende Photovoltaikanlage gelöst, wobei jede PV-Einheit mittels einer Schaltvorrichtung (T₁ bis T₁₀) aus der Parallelschaltung herausnehmbar ist und durch ein Gesamtstrommessgerät, welches den Gleichstrom durch die Parallelschaltung misst. Es ergeben sich die Ausgestaltungen und Vorteile des Verfahrens in analoger Weise.

Zur Beurteilung, inwieweit eine einzelne PV-Einheit gegebenenfalls von ihrer zu erwartenden Leistung abweicht, ist es zweckmäßiger Weise vorgesehen, dass eine einzige der PV-Einheiten mittels Strommessung, Spannungsmessung, Einstrahlungsintensität und direkter oder indirekter Temperaturmessung am Halbleiter als Referenz-PV-Einheit nach dem für Photovoltaikmodule zur Ermittlung der Normleistung festgelegten, standardisierten Testbedingungen (STC) ermittelt wird. Dann kann durch einen Vergleich der aktuell ermittelten Leistung einer beliebigen PV-Einheit mit der Normleistung (nach STC) eine erste Abschätzung erfolgen, inwieweit eine hinnehmbare oder eine weiterzuverfolgende Abweichung vorliegt.

Insbesondere bei gleich aufgebauten PV-Einheiten kann eine solche Abschätzung zur individuellen Performance einer PV-Einheit auch durch Vergleich mit einer Referenz-PV-Einheit erfolgen, die zuvor als solche definiert wurde. Dies ist vorteilhafterweise diejenige PV-Einheit, die bei der erstmaligen Leistungsermittlung an einem auf das Wetter bezogenen Idealtag, oder z.B. anlässlich der Inbetriebnahme der Photovoltaikanlage, die höchste Leistung erzeugt hat. Diese Leistung wird dann als bestmögliche Referenz für den verbauten Typ an PV-Einheit herangezogen. Weicht die Leistung einer anderen, beliebigen PV-Einheit von einem Grenzwert von z.B.97% der Referenzeinheitsleistung nach unten ab, wird auf eine schadhafte Montage oder ein defektes Bauteil geschlossen.

Das vorgestellte Verfahren ist nicht zur täglichen Anwendung vorgesehen, sondern eher zur Überprüfung der Leistungsfähigkeit der PV-Anlage in regelmäßigen Zeitabständen von z.B. einigen Monaten. Insofern ist es vertretbar, dass alle PV-Einheiten, die auf denselben Wechselrichter geschaltet sind, während aller Gleichstrommessungen auf eine konstante Spannung gehalten werden, indem der MPP (Maximal Power Point) - Regler des Wechselrichters auf den konstanten Spannungswert fixiert wird. Der für die Dauer der Messung auftretende Verlust über eine Fehlanpassung zum maximalen Leistungspunkt des Wechselrichters ist hinnehmbar. Ein wesentlicher Vorteil des Verfahrens ist dabei, dass mit der Betätigung eines einzigen Schalters eine unmittelbare Erkenntnis über den Leistungszustand der betroffenen PV-Einheit gewonnen werden kann.

Weitere Vorteile und Ausgestaltungen der Erfindung ergeben sich aus der Beschreibung eines Ausführungsbeispiels anhand der Figuren. Es zeigen:
- Fig.1: mit der Detailansicht von Fig. 1 a den prinzipiellen Aufbau eines größeren Photovoltaiksystems,
- Fig.2: eine Mess- und Auswerteeinheit zum Einsatz in einer Anlage nach der Fig. 1, und
- Fig.3: eine erläuternde Darstellung eines Messwandlerverhaltens mit seiner Δl zu I Abweichung.

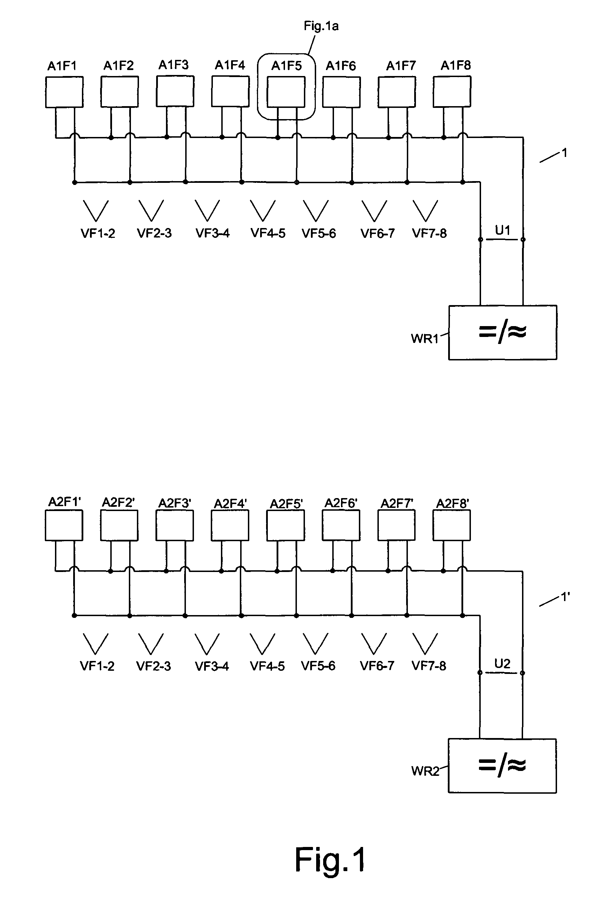

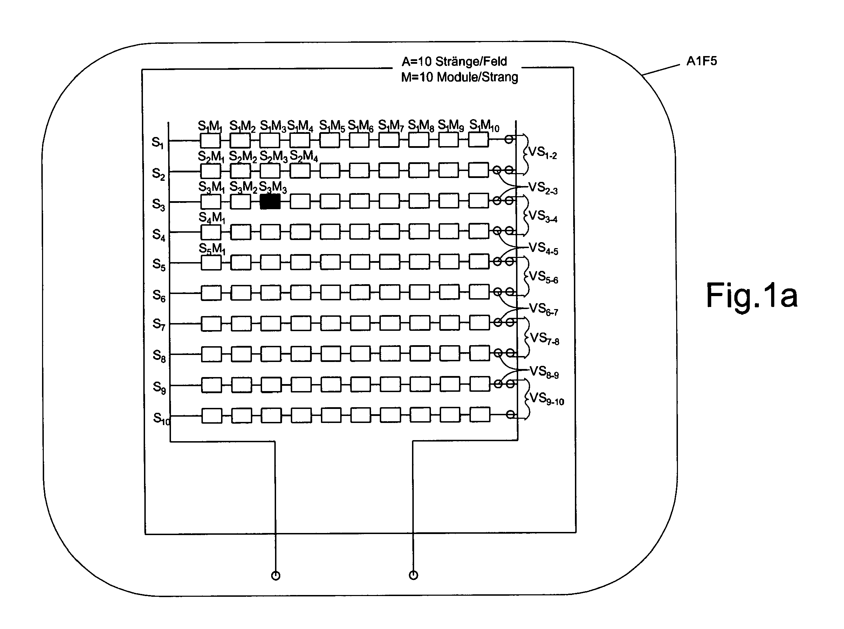

In der Figur 1 mit Detailansicht Figur 1 a ist mit A₁ bzw. mit A₂ eine erste und eine zweite Photovoltaikanlage bezeichnet, die bautechnisch gleich ausgeführt sind. Das heißt, dass jede PV-Anlage 1,1' acht Felder F₁ bis F₈ bzw. F_{1'} bis F₈, besitzt, bei deren Bezeichnung noch das Präfix A₁ für Anlage 1 bzw. A₂ für Anlage 2 vorangestellt ist. Im Detail wird nur auf die erste Anlage A₁ eingegangen.

Die erste Anlage A₁ besitzt acht Felder A₁F₁, A₁F₂, ... bis A₁F₈ die wiederum alle gleich aufgebaut sind. Wie es am Beispiel des Feldes A₁F₅ (Anlage 1, fünftes Feld) in der Detailfigur 1 a ersichtlich ist, besitzt jedes Anlagenfeld AF zehn elektrisch parallel geschaltete Stränge S, die mit S₁ bis S₁₀ durchnummeriert sind. Jeder Strang S₁ bis S₁₀ wiederum weist eine Reihenschaltung von 10 PV-Modulen M auf, die ihrerseits mit M₁ bis M₁₀ durchnummeriert sind. Ein einziges von den Einhundert PV-Modulen S₁M₁ bis S₁₀M₁₀ des dritten Feldes F₃ ist voll schwarz ausgelegt, nämlich das Photovoltaikmodul S₃M₃ im Feld F₃ von dem angenommen wird, dass es bei der Errichtung der Anlage fehlerfrei war und im Laufe der Zeit defekt geworden ist. Jedes Modul M besteht aus ca. 60 PV-Zellen, die in Reihe geschaltet sind. Die PV-Zelle ist die kleinste Einheit, in der die Sonnenstrahlen in Strom umgewandelt werden. Die 60 Zellen sind miteinander in Reihe geschaltet, so dass sich bei einer Arbeitsspannung von 1 Volt pro Zelle eine Spannung von 60 Volt über das Modul aufbaut. Bei zehn in Reihe geschalteten Modulen beträgt dann die Spannung über den gesamten Strang, auch als Strangspannung bezeichnet, 600 Volt. Wenn eine einzige der 10 mal 60 = 600 Zellen eines Strangs S nichtleitend wird, oder eine der Verbindungen zwischen den Zellen unterbrochen wird, fällt als Folge der Reihenschaltung der gesamte Strang S für die Stromlieferung aus. Beispielhaft ist ein solcher Fall bei dem Modul S₃M₃ unterstellt und es wird anschließend erläutert, wie der Strang S und später auch das Modul M identifiziert werden können.

Die zugrunde liegende Problematik ist deswegen von Bedeutung, da je nach Größe des PV-Systems, wie es im einleitenden Teil angesprochen ist, es nicht weiter auffällt, wenn ein einzelner Strang ausfällt, da sein Beitrag zur Gesamtleistung relativ gering ist. Andererseits verhält es sich wie bei einem tropfenden Wasserhahn, der nur geringe Mengen an Wasser verliert, sich diese geringe Mengen aber über die Zeit, im PV-Anlagenbau über mehrere Jahrzehnte zu einem bedeutenden Verlust addieren. So ist es aus wirtschaftlichen, wie auch aus in der Garantie begründeten Zwecken erforderlich, den Leistungszustand nicht nur der Gesamtanlage, sondern auch von einzelnen PV-Einheiten der Anlage beurteilen zu können.

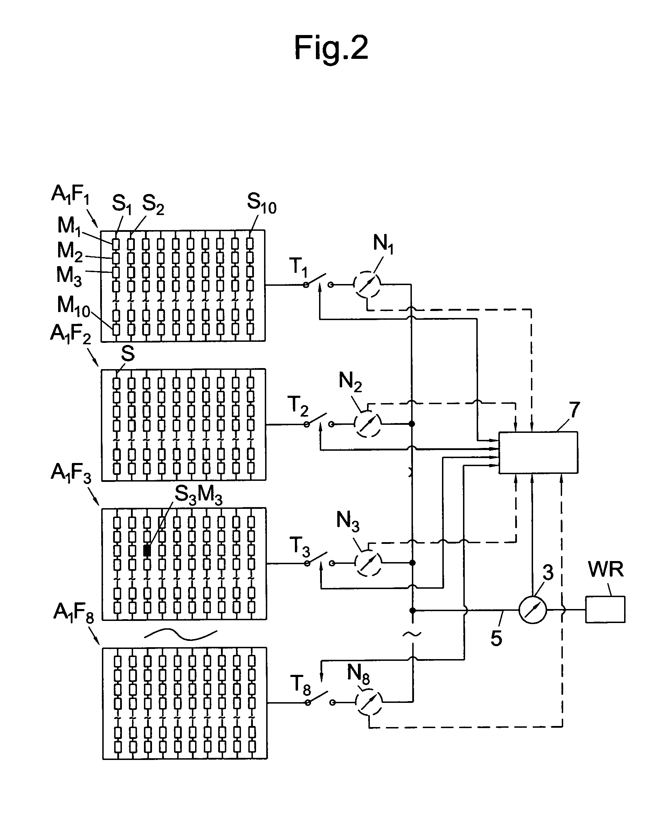

In der Figur 2 wird als PV-Einheit, in welcher eine Minderleistung untersucht werden soll, ein Feld F angesehen. In jedem der acht parallel geschalteten Felder F₁ bis F₈ der PV-Anlage 1 ist ein Trennschalter T₁ bis T₈ eingebaut, der es ermöglicht, das zugeordnete Feld F₁ bis F₈ aus der Parallelschaltung herauszunehmen und es wieder der Parallelschaltung zuzufügen. In Reihe zu jedem Trennschalter T₁ bis T₈ ist ein Stromsensor N₁ bis N₈ vorgesehen, mit dem der durch die Anschlussleitung des Feldes F fließende Gleichstrom l gemessen wird. Auf die Bedeutung der Stromsensoren N₁ bis N₈ wird später noch näher eingegangen.

Ein Gesamtstrommessgerät 3 misst den durch die gesamten Pfade der Parallelschaltung fließenden Gleichstrom l und ist im Verlauf einer Einspeise- oder Stromzuführungsleitung 5 vorgesehen. Die ermittelten Stromwerte werden einer Messwerterfassungs- und -auswerteeinheit 7 zugeführt, die die jeweils gemessenen Stromwerte des Referenzstrommessgerätes 3 miteinander vergleicht und gegebenenfalls bewertet.

Am Beispiel der PV-Anlage nach der Figur 1 kann davon ausgegangen werden, dass jedes Feld F einen Gesamtstrom zwischen 10 und 50 Ampere liefert, je nach Typ des verwendeten PV-Moduls. Der Einfachheit halber soll von einem Gesamtstrom von 10 Ampere ausgegangen werden. Ein fiktives Messergebnis nach Durchführung der Schritte i) bis v) könnte bei dem angenommenen Fehler im Photovoltaikmodul S₃M₃ im Feld F₃ zu folgenden Messergebnissen für die einzelnen Feldströme I_{F} führen, wobei von einem Gesamtstrom l bei allen geschlossenen acht Schaltern T₁ bis T₈ von 79 Ampere ausgegangen werden kann:

| | | | |
|---|---|---|---|
| l_{F1} | = | 10,1 A | ermittelt aus Differenz l_{T1} offen und l_{T1 geschlossen} |
| l_{F2} | = | 10,1 A | ermittelt aus Differenz l_{T2} offen und l_{T2 geschlossen} |
| l_{F3} | = | 9,0 A | ermittelt aus Differenz l_{T3 offen} und l_{T3 geschlossen} |
| l_{F4} | = | 9,9 A | ermittelt aus Differenz l_{T4 offen} und _{lT4 geschlossen} |
| l_{F5} | = | 9,8 A | ermittelt aus Differenz l_{T5} offen und l_{T5 geschlossen} |
| l_{F6} | = | 10,0 A | ermittelt aus Differenz l_{T6} offen und l_{T6 geschlossen} |
| l_{F7} | = | 10,0 A | ermittelt aus Differenz l_{T7 offen} und l_{T7 geschlossen}, |
| l_{F8} | = | 10,1 A | ermittelt aus Differenz l_{T8 offen} und l_{T8 geschlossen} |

An sich würde im Fehler freien Fall der theoretisch zu erwartende Gesamtstrom 1 für alle acht Felder F zusammen genommen 80 Ampere ergeben. Es wurden aber in der ersten Messung unter Schritt i) lediglich 79 Ampere gemessen. Anschließend werden die Schalter T der acht Felder F nacheinander geschlossen und wieder geöffnet, wobei sich obiges Bild ergibt: Das Feld F₃ ist in seiner Leistung um 10 % eingebrochen, was auf einen Fehler in diesem Feld schließen lässt. Ist jetzt in jedem Strang ein weiterer Trennschalter T' (nicht gezeigt) vorgesehen, mittels dem sich jeder einzelne Strang S₁ bis S₁₀ aus der Parallelschaltung von 10 Strängen S herauslösen oder wegschalten läßt, so würde sich beispielhaft folgende Situation darstellen:

| | | | |
|---|---|---|---|
| l_{S1} | = | 1,1 A | ermittelt aus Differenz l_{T1 offen} und l_{T1 geschlossen} |
| l_{S2} | = | 1,1 A | ermittelt aus Differenz l_{T2 offen} und l_{T2geschlossen} |
| l_{S3} | = | 0,0 A | ermittelt aus Differenz l_{T3 offen} und l_{T3geschlossen} |
| l_{S4} | = | 0,99 A | ermittelt aus Differenz l_{T4 offen} und l_{T4 geschlossen} |
| l_{S5} | = | 0,98 A | ermittelt aus Differenz l_{T5 offen} und l_{T5 geschlossen} |
| l_{S6} | = | 1,0 A | ermittelt aus Differenz l_{T6 offen} und l_{T6 geschlossen} |
| l_{S7} | = | 1,0 A | ermittelt aus Differenz l_{T7 offen} und l_{T7 geschlossen} |
| l_{S8} | = | 1,1 A | ermittelt aus Differenz l_{T8} offen und l_{T8 geschlossen} |
| l_{S9} | = | 1,0 A | ermittelt aus Differenz l_{T9 offen} und l_{T9 geschlossen} |
| l_{S10} | = | 1,0 A | ermittelt aus Differenz l_{T10 offen} und l_{T10 geschlossen} |

Der Gesamtstrom l = 9 Ampere setzt sich aus der Summe von nur neun anstelle der bei zehn Strängen zu erwartenden zehn Strangströme l zusammen, weil das defekte Modul S₃M₃ nichtleitend geworden ist und somit der komplette dritte Strang keinen Strom generiert. Auf diese Weise ist eine Eingrenzung des Fehlers alleine durch der Datenverwertung der Auswerteeinheit 7 möglich. Die Bestimmung des letztendlich schadhaften Moduls S₃M₃ erfolgt über das Trennen von Steckverbindungen, die die PV-Module jeweils miteinander verbinden, und das Ausmessen des jeweiligen Widerstands über die Module M.

Die Messung zur Kontrolle auf vorliegende Defekte kann regelmäßig jeden Tag erfolgen, da sie nur wenige Sekunden beansprucht. So wird ein frühzeitiges Auftreten von Defekten an Modulen M festgestellt.

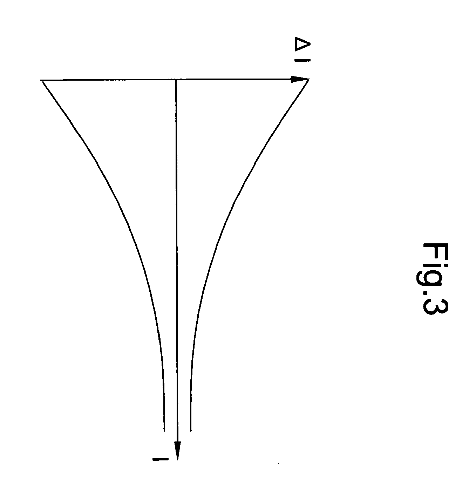

In der Figur 3 ist eine typische Kennlinie Δl zu l dargestellt, die die Abweichung der Messungenauigkeit Δl über den Gleichstrom l zeigt. Das Messprinzip der eingesetzten Wandler beruht auf einer Messung des vom Strom aufgebauten magnetischen Feldes. Bei kleinen Strömen l ist die Messtoleranz Δl des Stromwandlers relativ hoch im Vergleich zur Abweichung Δl, die bei hohen Strömen l vorliegt, da sich schwache Magnetfelder schwieriger genau ausmessen lassen als starke. Vorliegende Erfindung beruht auf dieser Erkenntnis, indem nur im Endbereich des Gesamtstrommessgerätes gemessen wird, in dem eine schwankungsarme, zuverlässige Messung möglich ist. Es wird also von dem klassischen Ansatz, in jedem Strompfad einer PV-Einheit ein eigenes Strommessgerät einzubauen, weggegangen. Der Nachteil, dass ein Trennschalter in jedem Strompfad vorhanden sein muss, wird durch die Ersparnis des eigenen präzisen Stromwandlers pro Pfad (oder Ersatz durch ein billiges Gerät) und den Gewinn an Aussagekraft der Messung mehr als kompensiert. Der nicht zwangsläufig erforderliche Stromwandler je Pfad ist nichtsdestotrotz in den Figuren gestrichelt als Option gezeigt, um gegebenenfalls andere Funktionen zu bedienen.

### Bezugszeichenliste

- A: Photovoltaikanlage
- F: Photovoltaikfeld
- S: Photovoltaikstrang
- M: Photovoltaikmodul
- V: Verhältnis
- WR: Wechselrichter
- N: Stromsensor
- T, T': Trennschalter
- 1: Vorrichtung zur Durchführung des Verfahrens
- 3: Gesamtstrommessgerät
- 5: Einspeiseleitung
- 7: Messwerterfassungs- und -auswerteeinheit

## Patentansprüche

1. Messverfahren zur Ermittlung eines Leistungsabfalls einer PV-Einheit (S,F) innerhalb einer mehrere, elektrisch parallel geschaltete PV-Einheiten (S,F) umfassenden Photovoltaikanlage, wobei jede PV-Einheit mittels einer Schaltvorrichtung (T₁ bis T₈) aus der Parallelschaltung herausnehmbar ist und ein Gesamtstrommessgerät (3) zur Messung des Gesamtstroms (1) durch alle PV-Einheiten der Parallelschaltung vorgesehen ist, mit folgenden Schritten:
i) der aufsummierte Gleichstrom aller parallel geschalteter PV-Einheiten wird mit dem Gesamtstrommessgerät (3) erfasst und dessen Wert abgespeichert,
ii) eine der PV-Einheiten wird mittels der ihr zugeordneten Schaltvorrichtung aus der Parallelschaltung herausgenommen,
iii) der aufsummierte Gleichstrom durch alle PV-Einheiten, bis auf die herausgenommene PV-Einheit, wird mit dem Gesamtstrommessgerät ermittelt und dessen Wert abgespeichert,
iv) der Schalter der herausgenommenen PV-Einheit wird geschlossen, so dass die PV-Einheit wieder in die Parallelschaltung integriert ist,
v) die Schritte ii) bis iv) werden für alle PV-Einheiten der Parallelschaltung durchgeführt, und
vii) die abgespeicherten Stromwerte werden einer Auswerteeinheit (7) zur Verfügung gestellt.

2. Messverfahren nach Anspruch 1, **dadurch gekennzeichnet, dass** in Schritt v) die Schritte i) bis iv) sukzessive für jede der PV-Einheiten wiederholt werden.

3. Messverfahren nach Anspruch 1 oder 2, **dadurch gekennzeichnet, dass** die PV-Einheiten (S,F,A) während der Verfahrensschritte i) bis v) auf den gleichen Betriebsspannungswert (U) gesetzt werden.

4. Messverfahren nach einem der Ansprüche 1 bis 3, **dadurch gekennzeichnet, dass** die Auswerteeinheit die zu einem Zeitpunkt t₀ abgespeicherten Strommesswerte mit den entsprechenden, zu einem späteren Zeitpunkt t₁ ermittelten Strommesswerten vergleicht.

5. Messverfahren nach einem der Ansprüche 1 bis 4, **dadurch gekennzeichnet, dass** in der Auswerteschaltung der in Schritt i) gemessene Strommesswert ins Verhältnis gesetzt wird zu dem in Schritt iii) gemessenen Strommesswert.

6. Messverfahren nach einem der Ansprüche 1 bis 5, **dadurch gekennzeichnet, dass** es bei PV-Anlagen mit mindestens 5 parallel geschalteten PV-Einheiten angewendet wird.

7. Messverfahren nach einem der Ansprüche 1 bis 6, **dadurch gekennzeichnet, dass** die abgespeicherten Strommesswerte aus dem arithmetischen Mittel einer Vielzahl von kurz hintereinander vorgenommenen Strommessungen gebildet werden.

8. Messverfahren nach einem der Ansprüche 1 bis 8, **dadurch gekennzeichnet, dass** jeder PV-Einheit ein eigener stationärer Stromsensor zugeordnet ist.

9. Vorrichtung zur Durchführung des Verfahrens nach einem der Ansprüche 1 bis 8, **gekennzeichnet durch** eine mehrere, elektrisch parallel geschaltete PV-Einheiten (S,F) umfassende Photovoltaikanlage, wobei jede PV-Einheit mittels einer Schaltvorrichtung (T₁ bis T₈) aus der Parallelschaltung herausnehmbar ist und **durch** ein Gesamtstrommessgerät, welches den Gleichstrom **durch** die Parallelschaltung misst.
